# EUROPEAN PATENT APPLICATION

(11) **EP 4 600 667 A1**
(43) Date of publication of application: **13.08.2025**
(21) Application number: 23875192.9
(22) Date of filing: 04.10.2023
(51) Int. Cl.: G01R 19/32, G01R 19/00, G01R 15/04, G01R 17/20, G01K 1/02, G01K 1/04, H01F 27/00, H01F 27/42, H01F 38/26

(54) **LOW-POWER VOLTAGE TRANSFORMER HAVING TEMPERATURE COMPENSATION APPLIED THERETO, AND TEMPERATURE COMPENSATION METHOD THEREOF**

(30) Priority: 05.10.2022 KR 20220127303
(71) Applicant: Hyosung Heavy Industries Corporation, Seoul 04144 (KR)
(72) Inventor: KIM, Do Jin, Changwon-si Gyeongsangnam-do 51526 (KR); KIM, Jong Wang, Anyang-si Gyeonggi-do 14067 (KR)
(74) Representative: Viering, Jentschura & Partner mbB Patent- und Rechtsanwälte
(86) International application number: PCT/KR2023/015203
(87) International publication number: WO 2024/076128

(57) **Abstract**

The present invention relates to a low-power voltage transformer (LPVT) with temperature compensation applied and a temperature compensation method thereof that are capable of increasing measurement values against changes in temperature of the LPVT and satisfy temperature requirements of IEC61869-6 by attaching and calibrating temperature sensors around the LPVT.

The LPVT with temperature compensation applied in accordance with the present invention comprises a voltage sensor with a first temperature sensor for sensing voltage of the digital transformer, and a secondary converter with a second temperature sensor for performing second conversion to transmit measured voltage information to a merging unit.

## Description

### TECHNICAL FIELD OF THE INVENTION

The present invention relates to a low-power voltage transformer with temperature compensation applied and a temperature compensation method thereof, and more particularly, to the low-power voltage transformer with temperature compensation applied and the temperature compensation method thereof to increase reliability of measurement values against changes in temperature of the low-power voltage transformer by compensating by changes in temperature thereof.

### BACKGROUND OF THE INVENTION

In the past, substations used a simple communication method of transmitting one-to-one signals by physical electric cables to monitor electric power equipment required for the process of electric power transmission, but modern substations are operated with a digital system that considers all signals for monitoring and controlling electric power equipment as sharable data.

Since it is the most important for such digitalized substations to be capable of sharing data between devices through a network, most of power generation companies and producers around the world have built such systems based on international standards such as IEC 61850.

As an internationally recognized communication standard protocol provided by the International Electrotechnical Commission (IEC), IEC 61850 provides generally applied rules for communications between medium-voltage devices and high-voltage switchgears and defines required system requirements.

For an instance, U.S. Patent No. 17313166 proposed a system for providing output of a low-power voltage transformer with a capacitor disposed within an insulating body around a conductor configured to electrically couple sensors, thereby forming a capacitive current divider.

However, even in this case, it was difficult to meet the requirements defined in IEC61869-6 as a test standard for verifying performance, durability, and safety of the low-power voltage transformer due to the unstable output of the low-power voltage transformer according to changes in temperature.

### DETAILED EXPLANATION OF THE INVENTION

### OBJECTS OF THE INVENTION

The object of the present invention is to provide a low-power voltage transformer (LPVT) with temperature compensation applied and a temperature compensation method thereof that are capable of increasing reliability of measurement values against changes in temperature of the LPVT.

The other object of the present invention is to provide a LPVT with temperature compensation applied and a temperature compensation method thereof that satisfy temperature requirements of IEC61869-6 by attaching and calibrating a temperature sensor around the LPVT.

### MEANS OF SOLVING THE PROBLEM

A low-power voltage transformer (LPVT) with temperature compensation applied in accordance with the present invention may comprise: a voltage sensor with a first temperature sensor for sensing voltage of the digital transformer, and a secondary converter with a second temperature sensor for performing second conversion to transmit measured voltage information to a merging unit.

Herein, the voltage sensor may include a capacitive voltage sensor for sensing capacitive voltage from a conductor by being installed coaxially with the conductor and an enclosure in insulation gas between the conductor and the enclosure and making capacitance, a capacitor connected in series with the capacitive voltage sensor and grounded, and a resistor connected in parallel with the capacitor.

In addition, the capacitor may be a capacitor in the form of a film with a low temperature coefficient.

Furthermore, the resistor may be a precision resistor with a low temperature coefficient.

Meanwhile, the secondary converter may include a controller for deriving correction coefficients for size and phase of output of the voltage sensor according to changes in temperature based on temperature measured by the first temperature sensor attached to the voltage sensor and the second temperature sensor built in the secondary converter, a voltage divider for dividing voltage of output of the voltage sensor based on control of the controller, and a phase controller for controlling phase of output of the voltage divider based on control of the controller.

At the time, the controller may control the voltage divider and the phase controller by deriving correction coefficients for size and phase according to changes in temperature that meet requirements of IEC61869-6.

Besides, the voltage divider may divide voltage based on a digital potentiometer.

In addition, the phase controller may control phase based on a digital potentiometer.

Meanwhile, a temperature compensation method of a LPVT with temperature compensation applied in accordance with the present invention may comprise: a first temperature sensing step of a first temperature sensor attached to a voltage sensor measuring temperature of the voltage sensor; a second temperature sensing step of a second temperature sensor built in a secondary converter measuring temperature inside the secondary converter; a temperature correction coefficients-deriving step of a controller deriving correction coefficients for size and phase of output of the voltage sensor according to changes in temperature based on the temperature measured by the first temperature sensor and the second temperature sensor; a gain controlling step of the controller dividing the output voltage of the voltage sensor based on the correction coefficients and controlling gain; and a phase controlling step of the controller controlling phase of output of the voltage divider based on the correction coefficients.

At the time, correction coefficients for size and phase according to changes in temperature that meet requirements of IEC61869-6 may be derived at the temperature correction coefficients-deriving step.

### EFFECTS OF THE INVENTION

A low-power voltage transformer (LPVT) with temperature compensation applied and a temperature compensation method thereof in accordance with the present invention have an effect of increasing reliability of measurement values against changes in temperature of the LPVT.

In addition, a LPVT with temperature compensation applied and a temperature compensation method thereof in accordance with the present invention have an effect of satisfying temperature requirements of IEC61869-6 by attaching and calibrating a temperature sensor around the LPVT.

### BRIEF DESCRIPTION OF THE DRAWINGS

Fig. 1 is a component block diagram showing a low-power voltage transformer with temperature compensation applied in accordance with one example embodiment of the present invention.
Fig. 2 is a block diagram more specifically illustrating a voltage sensor in Fig. 1.
Fig. 3 is a component block diagram more specifically illustrating a secondary converter in Fig. 1.
Fig. 4 is a flow chart showing a temperature compensation method of a low-power voltage transformer with temperature compensation applied in accordance with one example embodiment of the present invention.

### DETAILED DESCRIPTION OF THE PREFERRED EMBODIMENTS

The specific example embodiments of the present invention are explained by referring to attached drawings below.

Upon the explanation of the present invention, terms such as "first," "second," etc. may be used to explain a variety of components but the components may not be limited by such terms. The terms are used only for the purpose of distinguishing one component from another. For example, a first component may be named as a second component without being beyond the scope of the rights of the present invention and similarly, even a second component may be named as a first one.

If it is mentioned that a component is connected or linked to another component, it may be understood that the component may be directly connected or linked to the another component but also a third component may exist in between them.

The terms used in this specification are used only to explain specific examples of embodiments and they are not intended to limit the present invention. Unless a context clearly indicates a different meaning, any reference to singular may include plural ones.

In this specification, terms such as include or equip are used to indicate that there are features, numbers, steps, operations, components, parts, or combinations thereof, and it can be understood that existence or one or more different features, numbers, steps, operations, components, parts, or combinations thereof are not precluded.

Besides, for clearer explanation, shapes, sizes, etc. of elements in drawings may be exaggerated.

By referring to drawings attached below, a low-power voltage transformer with temperature compensation applied and a temperature compensation method thereof in accordance with the present invention are explained in more detail.

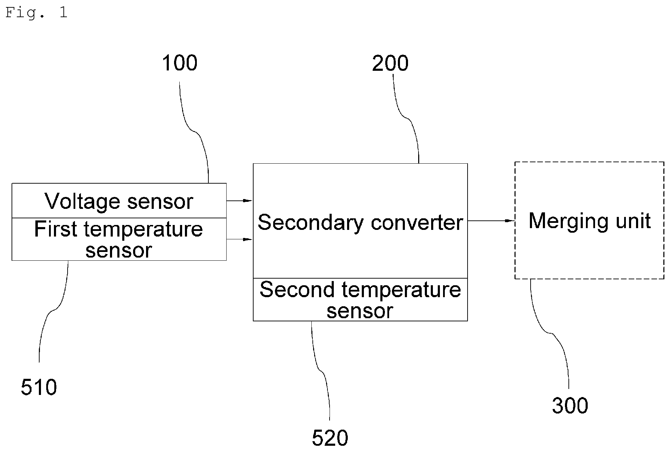

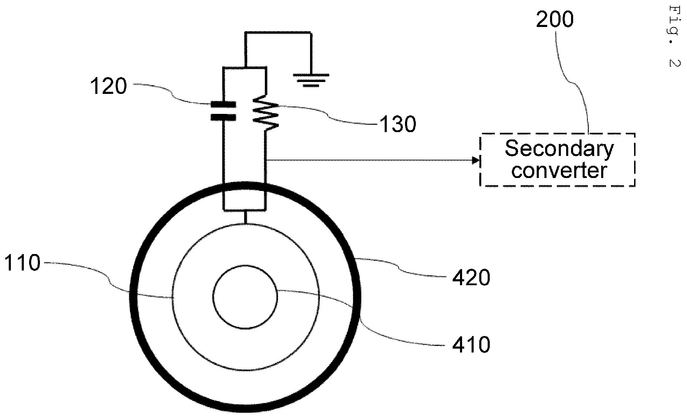

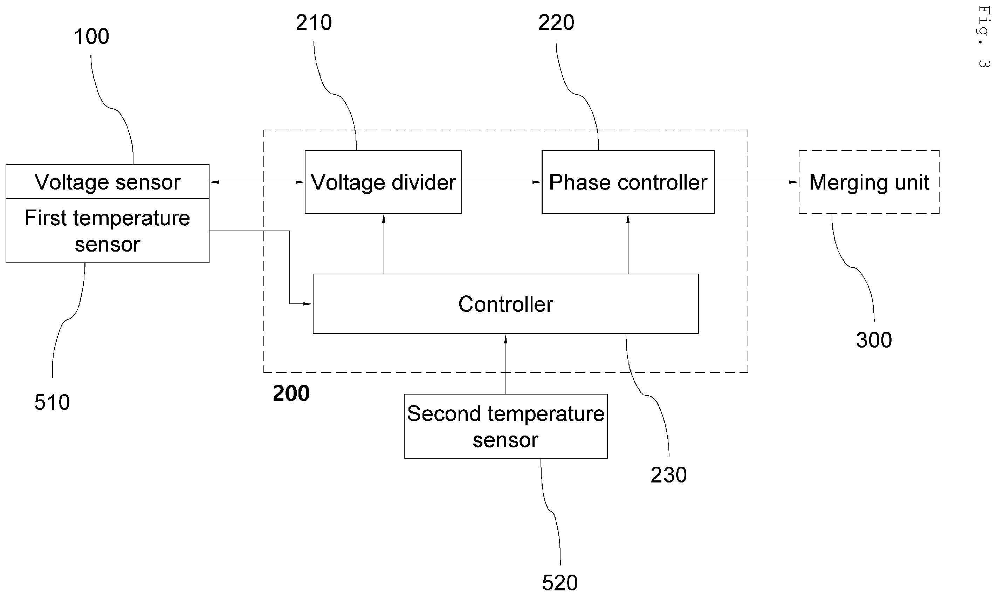

Fig. 1 is a component block diagram showing a low-power voltage transformer with temperature compensation applied in accordance with one example embodiment of the present invention, and Figs. 2 and 3 are specific block diagrams to make more detailed explanation.

By referring to Figs. 1 to 3, a low-power voltage transformer (LPVT) with temperature compensation applied in accordance with one example embodiment of the present invention is explained below.

A LPVT necessary for digital substations requires an accuracy class 0.2/3P even in operating temperature conditions between -40°C and 60°C. Due to changes in permittivity of SF gas in gas insulated switchgear (GIS) and changed values of an operational amplifier and passive elements of a secondary converter according to changes in operating temperature, the output voltage of the LPVT fluctuates.

In general, it is impossible to satisfy accuracy class 0.2/3P without separate temperature compensation. Accordingly, it is necessary to minimize output voltage due to temperature and to have a separate temperature compensation circuit to satisfy measuring accuracy required by a standard IEC61869-6.

Herein, for accuracy, voltage [kV], magnitude error (%), and phase error (minute) may be named as one group, and a unit P means protection.

For example, accuracy class 0.2/3P for a LPVT defined in the standard IEC61869-6 mean both metering and protection accuracy, wherein accuracy class 0.2 as a metering condition required to satisfy means accuracy accomplished within a maximum error of 0.2% at 80%, 100%, and 120% of rated current and accuracy class 3P as a protection condition required to satisfy means accomplished accuracy of 6%, 3%, 3%, 3%, and 3% at 2%, 20%, 80%, 100%, and 120% of the rated current, respectively.

To solve afore-mentioned problems, the present invention performs temperature compensation by attaching sensors that measure temperature, respectively, to a LPVT and a secondary converter 200.

To this end, by referring to Fig. 1, a LPVT with temperature compensation applied in accordance with one example embodiment of the present invention comprises: a voltage sensor 100 for sensing voltage of the digital transformer while a first temperature sensor 510 is attached to it; and a secondary converter 200 for performing second conversion to transmit measured voltage information to a merging unit 300 while a second temperature 520 is attached to it; and at this time, accuracy class 0.2/3P can be accomplished through temperature compensation performed by the secondary converter 200.

Fig. 2 is a block diagram more specifically illustrating the voltage sensor 100 in Fig. 1.

As can be seen in Fig. 2, the voltage sensor 100 includes: a capacitive voltage sensor 110 for sensing capacitive voltage from a conductor 410 by being installed coaxially with the conductor 410 and an enclosure 420 in insulation gas between the conductor 410 and the enclosure 420 and making capacitance; a capacitor 120 connected in series with the capacitive voltage sensor 110 and grounded; and a resistor 130 connected in parallel with the capacitor 120.

Herein, the capacitive voltage sensor 110 senses voltage by being attached to the LPVT and has a low temperature sensitivity.

Meanwhile, the enclosure 420 placed coaxially with a conductor 410 is outside of the voltage sensor 100. In addition, the capacitor 120 may be a capacitor in the form of a film with a low temperature coefficient, and the resistor 130 may be a precision resistor with a low temperature coefficient.

Fig. 3 is a component block diagram more specifically illustrating the secondary converter 200 in Fig. 1.

As can be seen in Fig. 3, the secondary converter 200 includes: a controller 230 for deriving correction coefficients for size and phase of output of the voltage sensor 100 according to changes in temperature based on temperature measured by the first temperature sensor 510 attached to the voltage sensor 100 and the second temperature sensor 520 built in the secondary converter 200; a voltage divider 210 for dividing voltage of output of the voltage sensor 100 based on control of the controller 230; and a phase controller 220 for controlling phase of output of the voltage divider 210 based on control of the controller 230.

At this time, the controller 230 derives correction coefficients for size and phase according to changes in temperature that meet requirements of IEC61869-6 and controls the voltage divider 210 and the phase controller 230 by using a digital potentiometer.

Herein, to derive correction coefficients, the controller 230 may derive a look-up table based on temperature measured by the first temperature sensor 510 and the second temperature sensor 520 and actual voltage of the LPVT, and apply results obtained through regression analysis or machine learning.

Accordingly, the LPVT with temperature compensation applied in accordance with the present invention may secure 0.2/3P class accuracy by attaching sensors for measuring temperature of the voltage sensor 100 and the secondary converter 200, deriving temperature correction coefficients that can satisfy a temperature cycling test under the standard IEC61869-6, and, then, performing temperature compensation based thereon.

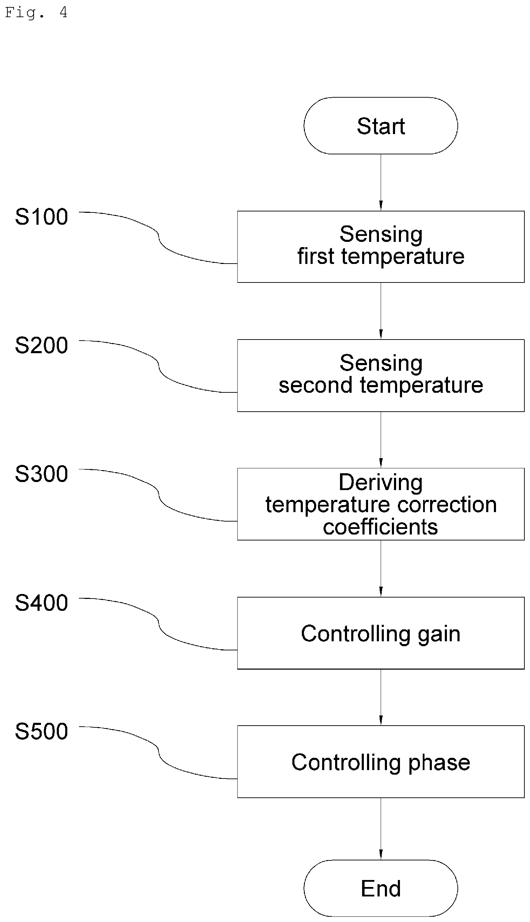

Fig. 4 is a flow chart showing a temperature compensation method of a LPVT with temperature compensation applied in accordance with one example embodiment of the present invention

As can be seen in Fig. 4, a temperature compensation method of a LPVT with temperature compensation applied comprises: a first temperature sensing step S100 of a first temperature sensor 510 attached to a voltage sensor 100 measuring temperature of the voltage sensor 100; a second temperature sensing step S200 of a second temperature sensor 520 attached in a secondary converter 200 measuring temperature inside the secondary converter 200; a temperature correction coefficients-deriving step S300 of a controller 230 deriving correction coefficients for size and phase of output of the voltage sensor 100 according to changes in temperature based on the temperature measured by the first temperature sensor 510 and the second temperature sensor 520; a gain controlling step S400 of the controller 230 dividing the output voltage of the voltage sensor 100 based on the correction coefficients and controlling gain; and a phase controlling step S500 of the controller 230 controlling phase of output of the voltage divider 210 based on the correction coefficients.

Herein, correction coefficients for size and phase according to changes in temperature that meet requirements of IEC61869-6 are derived at the temperature correction coefficients-deriving step S300.

Besides, to derive correction coefficients, the controller 230 may derive a look-up table based on temperature measured by the first temperature sensor 510 and the second temperature sensor 520 and actual voltage of the LPVT, and apply results obtained through regression analysis or machine learning.

By attaching sensors for measuring temperature of the voltage sensor 100 and the secondary converter 200, and deriving temperature correction coefficients that can satisfy a temperature cycling test under the standard IEC61869-6, the LPVT with temperature compensation applied and the temperature compensation method thereof in accordance with the present invention, therefore, may secure 0.2/3P class accuracy by performing temperature compensation based thereon.

Herein, for accuracy, voltage [kV], magnitude error (%), and phase error (minute) may be named as one group, and a unit P means protection. Since this has been explained above, detailed explanation is omitted.

As seen above, the LPVT with temperature compensation applied and the temperature compensation method thereof in accordance with the present invention may increase reliability of measurement values against changes in temperature of the LPVT and satisfy the temperature requirements of IEC61869-6 by attaching and calibrating temperature sensors around the LPVT.

What has been mentioned above includes one or more example embodiments. Of course, it may be recognized that they cannot describe all possible combinations of components or methods for the purpose of explaining afore-mentioned example embodiments but they may be added or replaced with a lot of additional combinations of various example embodiments by those skilled in the art. Accordingly, the explained example embodiments include all alternatives, modifications, and alternations within the intention and scope of what is claimed as attached below.

### Industrial Availability

The present invention relates to a low-power voltage transformer (LPVT) with temperature compensation applied and a temperature compensation method thereof, and they are available in a field of voltage transformers.

## Claims

1. A low-power voltage transformer (LPVT) with temperature compensation applied, comprising:
(a) a voltage sensor with a first temperature sensor for sensing voltage of the digital transformer; and
(b) a secondary converter with a second temperature sensor for performing second conversion to transmit measured voltage information to a merging unit.

2. The LPVT of Claim 1, wherein the voltage sensor includes: a capacitive voltage sensor for sensing capacitive voltage from a conductor by being installed coaxially with the conductor and an enclosure in insulation gas between the conductor and the enclosure and making capacitance; a capacitor connected in series with the capacitive voltage sensor and grounded; and a resistor connected in parallel with the capacitor.

3. The LPVT of Claim 2, wherein the capacitor is a capacitor in the form of a film with a low temperature coefficient.

4. The LPVT of Claim 2, wherein the resistor is a precision resistor with a low temperature coefficient.

5. The LPVT of Claim 1, wherein the secondary converter includes: a controller for deriving correction coefficients for size and phase of output of the voltage sensor according to changes in temperature based on temperature measured by the first temperature sensor attached to the voltage sensor and the second temperature sensor built in the secondary converter; a voltage divider for dividing voltage of output of the voltage sensor based on control of the controller; and a phase controller for controlling phase of output of the voltage divider based on control of the controller.

6. The LPVT of Claim 5, wherein the controller controls the voltage divider and the phase controller by deriving correction coefficients for size and phase according to changes in temperature that meet requirements of IEC61869-6.

7. The LPVT of Claim 5, wherein the voltage divider divides voltage based on a digital potentiometer.

8. The LPVT of Claim 5, wherein the phase controller controls phase based on a digital potentiometer.

9. A temperature compensation method of a LPVT with temperature compensation applied, comprising:
a first temperature sensing step of a first temperature sensor attached to a voltage sensor measuring temperature of the voltage sensor;
a second temperature sensing step of a second temperature sensor built in a secondary converter measuring temperature inside the secondary converter;
a temperature correction coefficients-deriving step of a controller deriving correction coefficients for size and phase of output of the voltage sensor according to changes in temperature based on the temperature measured by the first temperature sensor and the second temperature sensor;
a gain controlling step of the controller dividing the output voltage of the voltage sensor based on the correction coefficients and controlling gain; and
a phase controlling step of the controller controlling phase of output of the voltage divider based on the correction coefficients.

10. The method of Claim 9, wherein correction coefficients for size and phase according to changes in temperature that meet requirements of IEC61869-6 are derived at the temperature correction coefficients-deriving step.
